# EUROPÄISCHE PATENTSCHRIFT

(11) **EP 0 642 218 B1**
(45) Veröffentlichungstag und Bekanntmachung des Hinweises auf die Patenterteilung: **04.02.1998**
(21) Anmeldenummer: 94112398.6
(22) Anmeldetag: 09.08.1994
(51) Int. Cl.: H03F 3/45

(54) **Schaltungsanordnung mit gesteuerten Pinch-Widerständen**
Circuit with controlled pinch resistances
Circuit aux résistances à effet pinch contrôlés

(30) Priorität: 02.09.1993 DE 4329639
(43) Veröffentlichungstag der Anmeldung: 08.03.1995
(73) Patentinhaber: TEMIC TELEFUNKEN microelectronic GmbH, 74072 Heilbronn (DE)
(72) Erfinder: Böhme, Rolf, Dr., D-74177 Bad Friedrichshall (DE)
(74) Vertreter: Maute, Hans-Jürgen, Dipl.-Ing.

(56) Entgegenhaltungen:
- EP-A- 0 002 751
- US-A- 4 901 031
- US-A- 4 928 073
- PATENT ABSTRACTS OF JAPAN vol. 16, no. 429 (E-1261) 8. September 1992 & JP-A-04 150 207 (NEC) 22. Mai 1992
- PATENT ABSTRACTS OF JAPAN vol. 17, no. 661 (E-1471) 7. Dezember 1993 & JP-A-05 218 763 (NEC) 27. August 1993
- PATENT ABSTRACTS OF JAPAN vol. 17, no. 658 (P-1654) 6. Dezember 1993 & JP-A-05 216 549 (NEC) 27. August 1993
- PATENT ABSTRACTS OF JAPAN vol. 16, no. 150 (E-1189) 14. April 1992 & JP-A-04 004 610 (NEC) 9. Januar 1992

## Beschreibung

Die Erfindung betrifft eine Schaltungsanordnung mit wenigstens zwei, über deren Basis-Elektroden verbundenen Bipolar-Transistoren gemäß dem Oberbegriff des Patentanspruches 1.

In einer integrierten Schaltung entstehen Pinch-Widerstände, auch als eingeschnürte oder vergrabene Widerstände bezeichnet, wenn ein relativ hochohmiges Gebiet durch eine Sperrschicht sehr dünn oder schmal gemacht wird. Die Sperrspannung beeinflußt dann über die Breite der Sperrzone den Wert des Widerstandes. Bei einer bipolaren Standard-Technologie werden zwei Arten von Pinch-Widerständen ausgenutzt. Sogenannte n-leitende Pinch-Widerstände werden aus einer epitaktischen Schicht hergestellt, indem eine schmale Zone durch Inseldiffusion isoliert und außer an den Enden, die für die Kontaktfenster gebraucht werden, auch von der Oberfläche her durch eine p-Implantation abgedeckt wird. So entsteht ein Schlauch n-leitenden, hochohmigen Materials in einer allseitig p-leitenden Umgebung, die zum Substrat gehört. Derartige Pinch-Widerstände werden als stromstabilisierende Vorwiderstände eingesetzt, weil ihr Widerstand mit steigender Spannung zunimmt. Dagegen werden p-leitende Pinch-Widerstände mit der p-Implantation bzw. -Diffusion hergestellt, die auch für die Basis der npn-Transistoren verwendet wird. Durch Abdeckung mit der n⁺-Implantation für die Emitter entsteht eine vergrabene, hochohmige p-Schicht, die durch Kontaktierung an offen gelassenen Enden als Widerstand ausgebildet werden kann. Das umgebende n-leitende Material ist das der epitaktischen Schicht, das seinerseits durch Inseldiffusion isoliert und mit einem Kontakt versehen werden kann. Dieser Kontakt dient als Steuer-Elektrode für den Pinch-Widerstand. Solche p-leitenden Pinch-Widerstände aus der Basis-Implantation haben somit den Vorteil, daß sie über eine elektrisch freie Steuer-Elektrode verfügen.

Die Verwendung von gesteuerten Pinch-Widerständen zur Bias- bzw. Offset-Einstellung in bipolaren Differenzverstärkerstufen ist bekannt, z.B. aus JP-A-4-150 207 bzw. JP-A-5-218 763.

Der Aufbau dieses Pinch-Widerstandes entspricht dem eines SFET (Sperrschicht-FET). Weil aber die Durchbruchspannung der Emitter-Basis-Sperrschicht niedriger als die Abschnür- oder Pinch-off-Spannung ist, sind diese Elemente nicht wie übliche SFET zu gebrauchen. Ein für eine weitergehende Anwendung von Pinch-Widerständen sehr hinderlicher Nachteil ist die große Streubreite des Widerstandswertes, die unter üblichen technologischen Bedingungen einen Bereich 1:3 umfassen kann, ähnlich der Stromverstärkung der auf einem Chip befindlichen Transistoren.

In bipolaren Schaltungen für sehr kleine Versorgungsspannungen besteht das Problem, daß die verarbeitbaren Eingangsspannungshübe sehr klein werden. Betrachtet man z. B. einen einfachen npn-Transistor in Emitterschaltung, so muß die der Basis zugeführte Eingangsspannung mindestens den Wert der Basis-Emitter-Spannung haben, mit einem Zuschlag für den meist unvermeidlichen Emitterwiderstand. Die obere Grenze wird durch die Versorgungsspannung und den Spannungsbedarf für eine Ausgangsschaltung des Transistors festgelegt. Dann bleibt bei einer minimalen Versorgungsspannung von z. B. 1,2 V nur ein Spielraum von wenigen 100 mV für den zulässigen Eingangsspannungshub. Diese Einschränkung steht im Gegensatz zu den erreichbaren Ausgangsspannungshüben, die sich bei einer komplementären Ausgangsstufe dem Wert der Versorgungsspannung bis auf wenige 100 mV nähern können. So kann man in einer Schaltung mit 1,5 V Versorgungsspannung leicht einen Ausgangshub von 1,2 V erreichen, am Eingang aber kaum 0,5 V. Bei Trennverstärkern, Integratoren, Impedanzwandlern usw. ergeben sich dadurch erhebliche Schwierigkeiten in der Dimensionierung.

Ein weiterer Nachteil, insbesondere in Schaltungen mit Speicherfunktion oder tiefer unterer Grenzfrequenz sind die Eingangsströme, die in einer Bipolartechnologie für die Basen der Eingangstransistoren benötigt werden. Dies reduziert z. B. die bei einer Abtast-Halte-Schaltung oder einem Integrator erreichbaren Speicherzeiten und wird durch die oben erwähnten kleinen Spannungshübe noch verschärft.

Die Aufgabe der Erfindung besteht deshalb darin, in Schaltungsanordnungen der Bipolartechnologie der eingangs genannten Art den Eingangsspannungshub zu vergrößern und die Eingangsströme zu senken.

Erfindungsgemäß wird diese Aufgabe gelöst durch die Verwendung von Pinch-Widerständen mit Steuer-Elektroden, indem nach den kennzeichnenden Merkmalen des Patentanspruchs 1 als Emitterwiderstände der bipolaren Transistoren Pinch-Widerstände verwendet werden. Den Basis-Elektroden wird eine Hilfsspannung zugeführt, während die Kollektor-Elektroden der Bipolar-Transistoren als Ausgänge der Schaltung und die Steuer-Elektrode der Pinch-Widerstände als Eingänge dienen. Es wurde gefunden, daß Paare von Pinch-Widerständen gleicher Ausführung auf einem Chip um weniger als 0,5 % gegeneinander differieren, in einem Temperaturbereich von 120 °C, unabhängig von der genannten großen Streubreite im Absolutwert. Unter dieser Voraussetzung wird der Entwurf von Differenzstufen möglich, die die Steuerbarkeit von Pinch-Widerständen ausnutzen. Indem die Pinch-Widerstände gemäß der Erfindung am Punkt des tiefsten Potentials angeordnet sind, können die Steuer-Elektroden jedes beliebige, höhere Potential annehmen, bis in die Nähe der Durchbruchspannung der Sperrschicht, die gewöhnlich bei etwas über 5 V liegt. Die ausnutzbare Widerstandsänderung hängt von Dicke und Dotierung der Widerstandsbahn ab und erreicht leicht ein Verhältnis von 1:2 oder mehr. Das Verhältnis der Ströme in den beiden Transistoren ist nur geringfügig kleiner als das Verhältnis der Widerstände, so daß eine ausreichende Steuerwirkung erreicht wird. Bei kleinen Versorgungsspannungen von 1,2 bis 5 V und entsprechenden Spannungshüben ergeben sich brauchbare Dimensionierungsmöglichkeiten. Da die Steuer-Elektrode dem Anschluß einer Diode in Sperrichtung entspricht, sind die Eingangsströme wesentlich geringer als bei einer Schaltung mit Basis-Eingang.

Vorteilhafte Ausgestaltungen sind den Patentansprüchen 2 bis 9 zu entnehmen. Die Wirkungsweise der Erfindung und ihre verschiedenen Ausgestaltungen sollen nun anhand der Figuren erläutert werden, dazu zeigen:
- Figur 1: das Prinzipschaltbild einer Differenzstufe mit gesteuerten Pinch-Widerständen gemäß der Erfindung,
- Figur 2: die Differenzstufe gemäß Figur 1 mit separater Erzeugung der Hilfsspannung,
- Figur 3: die Differenzstufe gemäß Figur 1 mit interner Erzeugung der Hilfsspannung über einen Trennverstärker,
- Figur: die Erzeugung der Hilfsspannung über einen Emitterfolger,
- Figur 5: eine spezielle Ausführung als Trennverstärker der Differenzstufe nach Figur 1,
- Figur 6: eine Differenzstufe gemäß der Erfindung mit minimalem Aufwand,
- Figur 7: die Differenzstufe gemäß der Erfindung mit ausgangsseitigem Stromspiegel,
- Figur 8: ein Trennverstärker als Ausführungsbeispiel der Erfindung und
- Figur 9: eine erweiterte Beschaltung als Trennverstärker gemäß Figur 8.

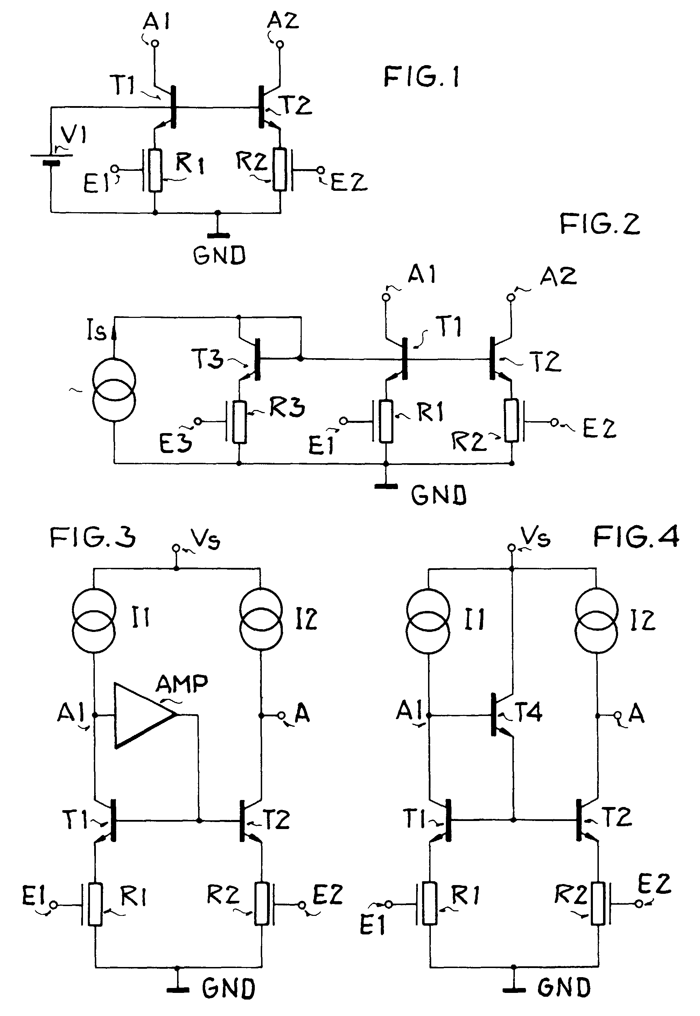

Das Prinzipschaltbild Figur 1 zeigt zwei bipolare npn-Transistoren T1 und T2, deren Basis-Elektroden von einer Hilfsspannung V1 versorgt werden und deren Emitter-Kollektoren über steuerbare Pinch-Widerstände R1 und R2 mit dem Bezugspunkt GND verbunden sind, wobei der Bezugspunkt nicht mit dem Masse-Anschluß übereinstimmen muß. Die Steuer-Elektroden E1 und E2 der Pinch-Widerstände sind die Eingänge, die Kollektor-Elektroden A1 und A2 der Transistoren T1 und T2 sind die Ausgänge der Schaltung.

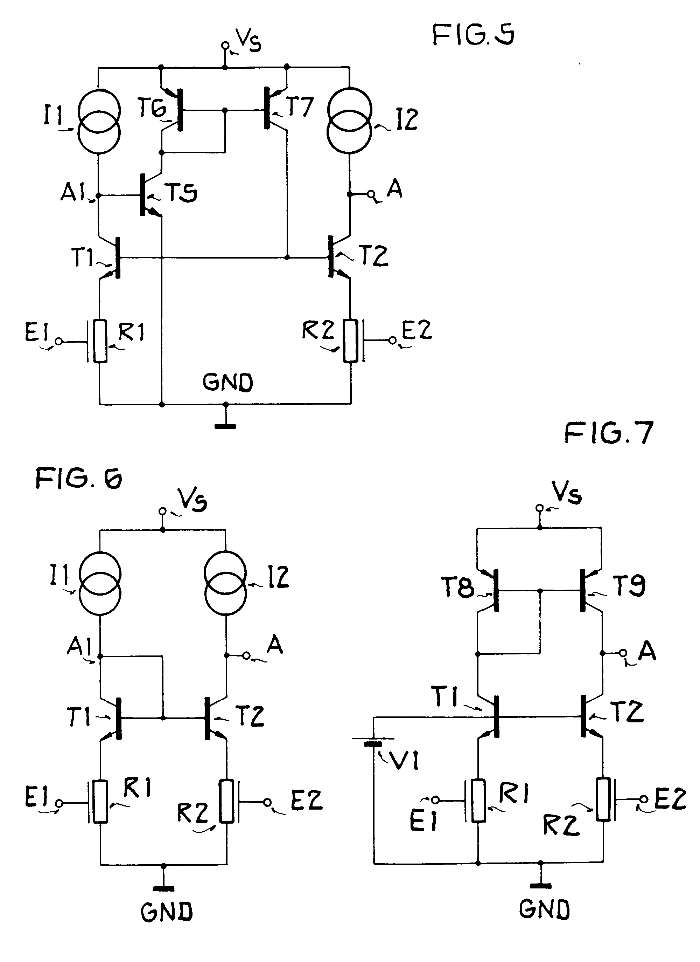

Für die vorgesehene Funktion werden den Ausgängen A1 und A2 geeignete Versorgungsspannungen zugeführt. Dies kann beispielsweise durch eine Stromspiegel-Schaltung erfolgen, wie es in Figur 7 dargestellt ist, womit ein ruhestromfreier, unsymmetrischer Ausgang A geschaffen wird. Im übrigen hängt die Gestaltung der Ausgangsschaltung vom Anwendungsfall ab und ist nicht Gegenstand der Erfindung. Durch eine an die Steuer-Elektroden E1 und E2 angelegte Spannung wird der Wert des zugeordneten Pinch-Widerstandes R1 und R2 eingestellt und der Strom durch den Transistor T1 oder T2 beeinflußt. Der Steuereffekt wird durch den Innenwiderstand des Transistors beeinträchtigt, weil eine bestimmte Widerstandsänderung eine prinzipiell kleinere Stromänderung ergibt. Dieser Verlust ist jedoch bereits bei einem Spannungsabfall von 0,25 V über dem Pinch-Widerstand R1 oder R2 (und Zimmertemperatur) unter 10 %. Die Schaltung hat insofern einen geringen Spannungsbedarf. Die Sperrschicht des Pinch-Widerstandes darf nicht in Durchlaßrichtung gepolt sein, weshalb die an den Steuer-Elektroden E1 und E2 angelegten Spannungen nicht niedriger als die Spannung am Emitter des zugeordneten Transistors sein soll, wobei eine Unterschreitung um einige zehntel Volt meist zulässig ist. Bei einer hohen Spannung an der Steuer-Elektrode E1 oder E2 ist dagegen das am Bezugspunkt befindliche Ende des Pinch-Widerstandes R1 oder R2 am stärksten belastet, wobei die maximal zulässige Spannung an der Steuer-Elektrode gleich der zulässigen Sperrspannung ist und nicht vom Spannungsabfall über dem Pinch-Widerstand R1 oder R2 abhängt. Ein größerer Spannungsabfall als etwa 0,3 V über dem Pinch-Widerstand bringt somit keinen wesentlichen Gewinn an Übertragungssteilheit, würde aber den verfügbaren Eingangsspannungshub an der Steuer-Elektrode E1 bzw. E2 reduzieren.

Figur 2 zeigte eine Möglichkeit, die Hilfsspannung V1 für die Basen der Transistoren T1 und T2 zu erzeugen. Zu diesem Zweck sind ein dritter Pinch-Widerstand R3 und ein dritter, als Diode geschalteter npn-Transistor T3 in Reihe geschaltet und werden vom Strom einer Stromquelle Is durchflossen. Die Steuer-Elektrode E3 des dritten Pinch-Widerstandes R3 wird an ein geeignetes Potential angeschlossen, durch dessen Wahl die Eigenschaften der Schaltung beeinflußt werden.

Der besondere Vorteil dieser Hilfsspannungserzeugung besteht darin, daß die große Streubreite im absoluten Wert der Pinch-Widerstände nicht zu Streuungen im Arbeitsstrom durch den Transistor T1 bzw. T2 führt. Im Hinblick auf die Stromquelle Is gleicht die Schaltung einem Stromspiegel mit zwei Ausgängen; eine verhältnisgleiche Änderung der Pinch-Widerstände R1 bis R3 verändert die Ausgangsströme an den Ausgängen A1 und A2 unter den beschriebenen Bedingungen wenig oder nicht. Die dritte Steuer-Elektrode E3 kann benutzt werden, um das Temperatur- oder Aussteuerungsverhalten zu beeinflussen. Verbindet man z. B. die Steuer-Elektroden E1 und E3, so ist der aus den Transistoren T3 und T1 gebildete Stromspiegel symmetrisch und der Strom am Ausgang A1 hängt nicht vom Wert der Eingangsspannung an den Steuer-Elektroden E1 und E3 ab. Der Ausgangsstrom am Ausgang A2 wird nur dann verschieden vom Strom am Ausgang A1, wenn die Spannung an der Steuer-Elektrode E2 verschieden von der Spannung an den Steuer-Elektroden E1 und E3 ist. Die Schaltung bietet damit die Fähigkeit der Gleichtaktunterdrückung.

Einer der beiden Ausgänge, beispielsweise A1, kann benutzt werden, die Hilfsspannung V1 ohne einen dritten Zweig zu erzeugen. Dies ist in Figur 3 unter Einsatz eines Verstärkers AMP und einer Stromquelle I1 ausgeführt. Der nicht-invertierende Verstärker AMP übernimmt die Spannung am Ausgang A1 und führt sie den Basis-Elektroden der Transistoren T1 und T2 zu. Der Verstärker AMP kann ein Buffer mit der Verstärkung 1 sein, oder er kann ein Differenzverstärker mit einer höheren Verstärkung sein, wenn der invertierende Eingang mit einer Hilfsspannung verbunden wird. Wenn der Eingangsstrom des Verstärkers AMP an A1 sehr klein gegenüber dem Strom I1 ist, legt die Stromquelle I1 den Strom durch den Transistor T1 und den Pinch-Widerstand R1 fest. Entsprechend wird die Spannung an den Basis-Elektroden der Transistoren T1 und T2 eingestellt. Der Strom durch den Transistor T2 unterscheidet sich nur dann vom Strom durch den Transistor T1, wenn die Steuerspannungen an E1 und E2 verschieden sind. Durch Einsatz einer zu I1 gleichgroßen Stromquelle I2, die mit der Kollektor-Elektrode des Transistors T2 verbunden ist, wird ein gleichstromfreier Ausgang A gebildet. Der Strom durch einen mit dem Ausgang A verbundenen und nicht dargestellten Verbraucher ist deshalb proportional zur Differenzspannung V_{E1}-V_{E2}, wenn V_{E1} bzw. V_{E2} die Spannung der Steuer-Elektrode E1 bzw. E2 bedeutet. Wegen der Nichtlinearität der Widerstandssteuerung ist die Proportionalitätskonstante von der Gleichtaktkomponente (V_{E1} + V_{E2})/2 abhängig.

Die Schaltung von Figur 4 wie auch die weiteren Schaltungen in den Figuren 5 bis 7 sind in ihrem Charakter spannungsgesteuerte Stromquellen. Schließt man am Ausgang A einen Kondensator an, so entsteht ein Integrator. Es bereitet keine Schwierigkeiten, einen Übertragungswiderstand von mehreren MOhm zu erzeugen, also von Widerstandswerten, die bei bipolarer Integration auch nicht annähernd zur Verfügung stehen. Dadurch lassen sich mit solchen Schaltungen tiefere Grenzfrequenzen bzw. höhere Integrationskonstanten oder Speicherzeiten erreichen, als es mit bisherigen Mitteln möglich war.

Die Schaltungen in Figur 4 und 5 zeigen einfachere Ausführungsbeispiele des Verstärkers AMP. In Figur 4 besteht der Verstärker aus einem Emitterfolger T4. Das hat allerdings zur Folge, daß der Spannungsbedarf in dieser Schaltung um die Basis-Emitter-Spannung des Transistors T4 anwächst, so daß diese Schaltung mindestens etwa Vs = 2 V benötigt. Die Schaltung nach Figur 5 vermeidet diesen Nachteil und legt die Spannung am Ausgang A1 auf die Basisspannung eines Transistors T5 fest, dessen Emitter-Elektrode auf dem Bezugspunkt GND der Schaltung liegt. Die Kollektor-Elektrode ist dagegen über eine aus zwei Transistoren T6 und T7 aufgebaute Stromspiegel-Schaltung mit dem Betriebspotential Vs der Schaltung verbunden. Über diesen Stromspiegel wird die Basisleitung für die Transistoren T1 und T2 gesteuert und versorgt.

Mit geringen Abstrichen am Verhalten kann der Verstärker von Figur 3 nach Figur 6 ganz weggelassen und durch eine Verbindung vom Ausgang A1 zur Basisverbindung der Transistoren T1 und T2 ersetzt werden. Es ergibt sich ein größerer Offset der Eingangsspannung V_{E1}-V_{E2} als in den vorausgegangenen Schaltungen, weil vom Strom der Quelle I1 zwei Basisströme abgezweigt werden. Die Unsymmetrie kann durch einen gegenüber dem Pinch-Widerstand R2 etwas größeren Pinch-Widerstand R1 oder einen gegenüber dem Strom I2 größeren Strom I1 kompensiert werden. Diese Schaltung kann verwendet werden, wenn an die Offsetspannung keine höheren Anforderungen gestellt sind.

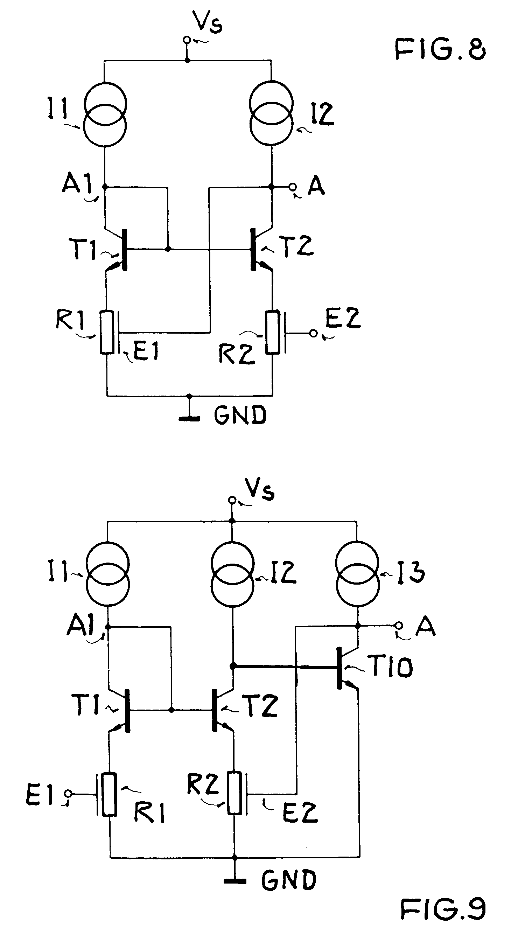

Mit den Schaltungen nach den Figuren 8 und 9 wird die Funktion eines Trennverstärkers realisiert. Dazu wird in Figur 8 in einer Grundschaltung entsprechend Figur 6 der Ausgang A an der Kollektor-Elektrode des Transistors T2 mit dem Eingang E1 verbunden. Dies wirkt als Spannungsgegenkopplung und hat zur Folge, daß der Ausgang A dem Eingang E2 nachgeführt wird. Der Verstärkungsfaktor ist allerdings etwas kleiner als eins, weil die Schleifenverstärkung nicht sehr groß ist. Die Schaltung nach Figur 9 beseitigt diesen Mangel durch Einschleifen eines zusätzlichen npn-Verstärkertransistors T10 mit einer Stromquelle I3 an dessen Kollektor-Elektrode. Die Basis-Elektrode dieses Transistors T10 liegt an der Kollektor-Elektrode A2 des Transistors T2, während dessen Emitter-Elektrode auf dem Bezugspunkt GNG der Schaltung liegt. Die Kollektor-Elektrode dieses Transistors T10 bildet den Ausgang A der Schaltung und ist gleichzeitig mit der Steuer-Elektrode E2 verbunden. Mit dieser Schaltung wird eine höhere Stromergiebigkeit des Ausgangs A erreicht. Wegen der zusätzlichen Phasenumkehr im Transistor T10 vertauschen die Eingänge E1, E2 ihre Phasenbeziehung, weshalb der Ausgang A mit dem nunmehr invertierten Eingang E2 verbunden werden muß.

Die in den Figuren 1 bis 9 beschriebenen Schaltungen können auch mit Transistoren des entgegengesetzten Leitfähigkeitstyps aufgebaut werden. Entsprechend müssen die Polaritäten angepaßt werden und anstatt p-Pinch-Widerstände n-Pinch-Widerstände verwendet werden.

Schließlich kann die Erfindung auch für Differenzverstärker mit mehr als zwei Zweigen eingesetzt werden.

## Patentansprüche

1. Schaltungsanordnung mit wenigstens zwei, über deren Basis-Elektroden verbundenen Bipolar-Transistoren (T1, T2), die jeweils einen Emitterwiderstand (R1, R2) aufweisen welche mit einem Referenzpotential (GND) für Versorgungs-spannungen (V1, Vₛ) verbunden sind, gekennzeichnet durch folgende Merkmale:
a) als Emitterwiderstand wird jeweils ein Pinch-Widerstand verwendet, der zur Steuerung dessen Widerstandswertes eine Steuer-Elektrode (E1, E2) aufweist,
b) die beiden Steuer-Elektroden der Pinch-Widerstände (R1, R2) dienen jeweils als Eingang (E1, E2) der Schaltungsanordnung,
c) ferner wird den Basis-Elektroden der Transistoren (T1, T2) eine Hilfsspannung (V1) zugeführt und
d) schließlich dienen die Kollektor-Elektroden der Transistoren (T1, T2) als Ausgänge (A1, A2).

2. Schaltungsanordnung nach Anspruch 1, dadurch gekennzeichnet, daß die Pinch-Widerstände (R1, R2) jeweils die Emitter-Elektrode der Transistoren (T1, T2) mit dem Referenzpotential der Schaltungsanordnung verbinden.

3. Schaltungsanordnung nach Anspruch 1 oder 2, dadurch gekennzeichnet, daß die Hilfsspannung (V1) über einer Reihenschaltung aus einem dritten als Diode geschalteten Transistor (T3) und einem weiteren Pinch-Widerstand (R3) abgegriffen wird, wobei die Reihenschaltung von einem Versorgungsstrom (Is) durchflossen wird.

4. Schaltungsanordnung nach Anspruch 1 oder 2, dadurch gekennzeichnet, daß dem ersten Ausgang (R1) ein Strom (I1) zugeführt wird und daß der Eingang eines Verstärkers (AMP) mit diesem ersten Ausgang (A1) und der Ausgang des Verstärkers (AMP) mit den Basis-Elektroden der Transistoren (T1, T2) verbunden ist.

5. Schaltungsanordnung nach Anspruch 4, dadurch gekennzeichnet, daß der Verstärker (AMP) ein Differenzverstärker ist, dessen invertierender Eingang mit dem Ausgang des Verstärkers oder einer Hilfsspannung verbunden ist.

6. Schaltungsanordnung nach Anspruch 4, dadurch gekennzeichnet, daß der Verstärker (AMP) ein Emitterfolger (T4) ist.

7. Schaltungsanordnung nach Anspruch 4, dadurch gekennzeichnet, daß der Verstärker (AMP) aus einem Transistor (T5) in Emitterschaltung und einem an dessen Kollektor-Elektrode angeschlossener Stromspiegel-Schaltung (T6, T7) besteht, wobei der Ausgang dieser Stromspiegel-Schaltung den Ausgang des Verstärkers (AMP) bildet.

8. Schaltungsanordnung nach Anspruch 1 oder 2, dadurch gekennzeichnet, daß der erste Ausgang (A1) mit den Basis-Elektroden der Transistoren (T1, T2) verbunden ist und von einer Stromquelle (I1) versorgt wird.

9. Schaltungsanordnung nach einem der vorangehenden Ansprüche, dadurch gekennzeichnet, daß der zweite Ausgang (A) mit dem ersten Eingang (E1) verbunden ist.

10. Schaltungsanordnung nach einem der Ansprüche 1 bis 8, dadurch gekennzeichnet, daß ein Transistor (T10) in Emitterschaltung basisseitig mit dem zweiten Ausgang (A2) und kollektorseitig mit dem zweiten Eingang (E2) verbunden ist und dessen Kollektor-Elektrode als Ausgang (A) der Schaltungsanordnung dient.

## Claims

1. A circuit arrangement with at least two bipolar transistors (T1, T2) which are connected via their base electrodes and which each have an emitter resistor (R1, R2) which are connected to a reference potential (GND) for supply voltages (V1, Vₛ), characterised by the following features:
a) a pinch resistor, which has a control electrode (E1, E2) for the control of its resistance value, is in each case used as emitter resistor,
b) the two control electrodes of the pinch resistors (R1, R2) in each case serve as input (E1, E2) of the circuit arrangement,
c) additionally, an auxiliary voltage (V1) is fed to the base electrodes of the transistors (T1, T2) and
d) finally the collector electrodes of the transistors (T1, T2) serve as outputs (A1, A2).

2. A circuit arrangement according to Claim 1, characterised in that the pinch resistors (R1, R2) in each case connect the emitter electrode of the transistors (T1, T2) to the reference potential of the circuit arrangement.

3. A circuit arrangement according to Claim 1 or 2, characterised in that the auxiliary voltage (V1) is tapped via a series circuit comprising a third transistor (T3) connected as diode and a further pinch resistor (R3), the series circuit being traversed by a supply current (Is).

4. A circuit arrangement according to Claim 1 or 2, characterised in that the first output (R1) is supplied with a current (I1) and that the input of an amplifier (AMP) is connected to this first output (A1) and the output of the amplifier (AMP) is connected to the base electrodes of the transistors (T1, T2).

5. A circuit arrangement according to Claim 4, characterised in that the amplifier (AMP) is a differential amplifier whose inverting input is connected to the output of the amplifier or an auxiliary voltage.

6. A circuit arrangement according to Claim 4, characterised in that the amplifier (AMP) is an emitter follower (T4).

7. A circuit arrangement according to Claim 4, characterised in that the amplifier (AMP) comprises a transistor (T5) with a common emitter connection and a current mirror circuit (T6, T7) connected to the collector electrode of said transistor (T5), the output of this current mirror circuit forming the output of the amplifier (AMP).

8. A circuit arrangement according to Claim 1 or 2, characterised in that the first output (A1) is connected to the base electrodes of the transistors (T1, T2) and is fed by a current source (I1).

9. A circuit arrangement according to one of the preceding claims, characterised in that the second output (A) is connected to the first input (E1).

10. A circuit arrangement according to one of Claims 1 to 8, characterised in that a transistor (T10) with a common emitter connection is connected by its base to the second output (A1) and by its collector to the second input (E2) and the collector electrode of said transistor (T10) serves as output (A) of the circuit arrangement.

## Revendications

1. Circuit équipé d'au moins deux transistors bipolaires (T1, T2) réunis par leurs électrodes de base, qui présentent chacun une résistance d'émetteur (R1, R2) qui sont reliées à un potentiel de référence (GND) pour des tensions d'alimentation (V1, Vₛ), caractérisé en ce que :
a) en tant que résistance d'émetteur est utilisée une résistance à effet de pincement, qui présente une électrode de commande (E1, E2) en vue de la commande se sa valeur ohmique,
b) les deux électrodes de commande des résistances à effet de pincement (R1, R2) servent respectivement d'entrée (E1, E2) du circuit,
c) en outre, aux électrodes de base des transistors (T1, T2) est appliquée une tension auxiliaire (V1) et d) enfin les électrodes de collecteur des transistors (T1, T2) servent de sorties (A1, A2).

2. Circuit selon la revendication 1, caractérisé en ce que les résistances à effet de pincement (R1, R2) de chaque électrode d'émetteur des transistors (t1, T2) sont reliées au potentiel de référence du circuit.

3. Circuit selon la revendication 1 ou 2, caractérisé en ce que la tension auxiliaire (V1) est prélevée par l'intermédiaire d'un montage série se composant d'un troisième transistor (T3) monté en diode et d'une autre résistance à effet de pincement (R3), le montage série étant parcouru par un courant d'alimentation (Is).

4. Circuit selon la revendication 1 ou 2, caractérisé en ce qu'à la première sortie (R1) est appliqué un courant (I1) et en ce que l'entrée d'un amplificateur (AMP) est reliée à cette première sortie (A1) et la sortie de l'amplificateur (AMP) avec les électrodes de base des transistors (T1, T2).

5. Circuit selon la revendication 4, caractérisé en ce que l'amplificateur (AMP) est un amplificateur différentiel, dont l'entrée avec inversion est reliée à la sortie de l'amplificateur ou à une tension auxiliaire.

6. Circuit selon la revendication 4, caractérisé en ce que l'amplificateur (AMP) est un émetteur asservi (T4).

7. Circuit selon la revendication 4, caractérisé en ce que l'amplificateur (AMP) se compose d'un transistor (T5) en émetteur commun et d'un circuit miroir de courant (T6, T7) relié à l'électrode de collecteur de celui-ci, la sortie de ce circuit miroir de courant constituant la sortie de l'amplificateur (AMP).

8. Circuit selon la revendication 1 ou 2, caractérisé en ce que la première sortie (A1) est reliée aux électrodes de base des transistors (T1, T2) et est alimentée par une source de courant (I1).

9. Circuit selon l'une quelconque des revendications précédentes, caractérisé en ce que la seconde sortie (A) est reliée à la première entrée (E1).

10. Circuit selon l'une des revendications 1 à 8, caractérisé en ce qu'un transistor (T10) en émetteur commun est relié côté base avec la seconde sortie (A2) et côté transistor avec la seconde entrée (E2) et dont l'électrode de collecteur sert de sortie (A) du circuit.
